# EUROPEAN PATENT SPECIFICATION

(11) **EP 3 098 838 B1**
(45) Date of publication and mention of the grant of the patent: **27.01.2021**
(21) Application number: 15739877.7
(22) Date of filing: 21.01.2015
(51) Int. Cl.: H01L 21/687, H01L 21/67, H01J 37/32, H01L 21/683

(54) **PLASMA TREATMENT DEVICE AND WAFER TRANSPORTATION TRAY**
PLASMABEHANDLUNGSVORRICHTUNG UND WAFERTRANSPORTPLATTE
DISPOSITIF DE TRAITEMENT PAR PLASMA ET PLATEAU DE TRANSPORT DE TRANCHE

(30) Priority: 22.01.2014 JP 2014009682
(43) Date of publication of application: 30.11.2016
(73) Proprietor: ULVAC, Inc., Chigasaki-shi, Kanagawa 253-8543 (JP)
(72) Inventor: NAKAMURA Toshiyuki, Chigasaki-shi Kanagawa 253-8543 (JP); MORIGUCHI Naoki, Chigasaki-shi Kanagawa 253-8543 (JP); KAMIMURA Ryuichiro, Chigasaki-shi Kanagawa 253-8543 (JP); OSADA Yamato, Chigasaki-shi Kanagawa 253-8543 (JP); AIHARA Tsuyoshi, Chigasaki-shi Kanagawa 253-8543 (JP)
(74) Representative: Zacco GmbH
(86) International application number: PCT/JP2015/051523
(87) International publication number: WO 2015/111616

(56) References cited:
- EP-A1- 2 450 948
- WO-A1-2011/001978
- JP-A- H1 079 417
- JP-A- H05 259 048
- JP-A- H09 162 272
- JP-A- H11 168 056
- JP-A- 2003 100 856
- JP-A- 2004 031 449
- JP-B2- 3 596 127
- JP-U- H02 135 141
- US-B1- 6 558 508

## Description

### TECHNICAL FIELD

The present invention relates to a plasma treatment apparatus and a wafer transportation tray, and more particularly, to fixture of a wafer transfer tray.

Priority is claimed on Japanese Patent Application No. 2014-009682, filed January 22, 2014.

### BACKGROUND ART

In the related art, in manufacture of a semiconductor device, when a plurality of wafers or the like are batch-processed through plasma treatment, the batch processing is generally performed using a wafer transfer tray. For example, a plurality of wafers are placed on one surface of the wafer transfer tray. The wafer transfer tray is placed on a supporter of a plasma treatment apparatus. The supporter acts as one electrode when the plasma treatment is performed.

When the wafers are plasma-treated in the plasma treatment apparatus, if the wafers are fixed to the wafer transfer tray using a pressing means, fixation of the wafers is time-consuming and thus an effective area in a wafer surface is reduced. For this reason, for example, in Patent Literature 1, a plasma treatment apparatus for fixing wafers to a wafer transfer tray using electrostatic attraction is disclosed.

Meanwhile, when the wafers are plasma-treated in the plasma treatment apparatus, the temperature of the wafer transfer tray is increased by plasma. For this reason, in the above-mentioned plasma treatment apparatus, the plasma treatment apparatus configured to form a flow path through which a cooling gas flows between the wafer transfer tray and a supporter that supports the wafer transfer tray, and cool the wafer transfer tray using a cooling gas is disclosed.

In the plasma treatment apparatus having the above-mentioned configuration, in order to minimize leakage of the cooling gas flowing between the wafer transfer tray and the supporter, the wafer transfer tray and the supporter should closely contact to each other. For this reason, a mechanical clamp configured to mechanically attach the wafer transfer tray and the supporter is formed.

### PRIOR ART DOCUMENTS

### PATENT DOCUMENTS

[Patent Literature 1] Re-publication of PCT International Publication No. WO2010/09554
[Patent Literature 2] Document JP 3596127 B discloses a thin plate holder configured for conveying a semiconductor substrate, said holder including an electrostatic chuck.

### SUMMARY OF THE INVENTION

### PROBLEMS TO BE SOLVED BY THE INVENTION

However, the above-mentioned plasma treatment apparatus has a configuration of mechanically attaching the wafer transfer tray and the supporter that supports the wafer transfer tray using the mechanical clamp. For this reason, an operation when the wafer transfer tray is fixed to the supporter becomes complicated. In particular, structurally, since the mechanical clamp comes in contact with a circumferential edge portion of the wafer transfer tray to be fixed thereto, adhesion between the wafer transfer tray and the supporter may be decreased in the vicinity of a central portion of the wafer transfer tray.

In consideration of the above-mentioned problems, the present invention is directed to provide a plasma treatment apparatus and a wafer transfer tray in which the wafer transfer tray and a supporter that supports the wafer transfer tray can be in close contact to each other easily and uniformly across an entire support surface.

### MEANS FOR SOLVING THE PROBLEMS

In order to solve the problems, some aspects of the present invention have provided the following plasma treatment apparatus and wafer transfer tray. That is, a plasma treatment apparatus according to a first aspect of the present invention includes a wafer transfer tray having a first surface and a second surface opposite to the first surface, and configured to hold a wafer on the first surface; a cooling unit configured to cool the wafer transfer tray; a conductive supporter configured to support the second surface of the wafer transfer tray; and a double-surface electrostatic attractor configured to electrostatically attract the wafer to the first surface of the wafer transfer tray and electrostatically attract the supporter to the second surface of the wafer transfer tray.

In the first aspect, the wafer transfer tray may have a base formed of an insulating body, a first conductive layer for electrostatic attraction embedded at a position in the vicinity of a first surface of the base, and a second conductive layer for electrostatic attraction embedded at a position in the vicinity of a second surface of the base and electrically connected to the first conductive layer, a direct current voltage application unit configured to apply a direct current voltage may be connected to the first conductive layer and the second conductive layer, and a ground section may be connected to the supporter so that the supporter has a ground potential with respect to the direct current voltage.

In the first aspect, the wafer transfer tray may have a base formed of a high resistance body having a resistance value of 10⁸ Ω or more and 10¹¹ Ω or less, and a first conductive layer for electrostatic attraction embedded at a position in the vicinity of the first surface of the base, a direct current voltage application unit configured to apply a direct current voltage may be connected to the first conductive layer, and a ground section may be connected to the supporter so that the supporter has a ground potential with respect to the direct current voltage.

In the first aspect, the wafer transfer tray may have a base formed of an insulating body, a first conductive layer for electrostatic attraction embedded at a position in the vicinity of the first surface of the base, and a conductor disposed to be exposed to the second surface of the base, the supporter may have an insulating layer disposed on a support surface facing to the wafer transfer tray and in which a second conductive layer for electrostatic attraction is embedded, and a direct current voltage application unit configured to apply a direct current voltage may be connected to the first conductive layer and the second conductive layer.

In the first aspect, the wafer transfer tray may have a base formed of a metal, a first insulating layer disposed at the first surface of the base and in which a first conductive layer for electrostatic attraction is embedded, and a second insulating layer disposed at the second surface of the base and in which a second conductive layer for electrostatic attraction electrically connected to the first conductive layer is embedded, a direct current voltage application unit configured to apply a direct current voltage may be connected to the first conductive layer and the second conductive layer, and a ground section may be connected to the supporter so that the supporter has a ground potential with respect to the direct current voltage.

In the first aspect, the wafer transfer tray may have a base formed of a metal, and a first insulating layer disposed at the first surface of the base and in which a first conductive layer for electrostatic attraction is embedded, the supporter may have a second insulating layer disposed at a support surface facing to the wafer transfer tray and in which a second conductive layer for electrostatic attraction is embedded, and a direct current voltage application unit configured to apply a direct current voltage may be connected to the first conductive layer and the second conductive layer.

In the first aspect, the wafer transfer tray may have a base formed of a metal that constitutes a conductor for electrostatic attraction, and an insulating layer configured to cover an outer circumferential surface of the base, a direct current voltage application unit configured to apply a direct current voltage may be connected to the base, and a ground section may be connected to the supporter so that the supporter has a ground potential with respect to the direct current voltage.

In the first aspect, the wafer transfer tray may have a base formed of a metal that constitutes a conductor for electrostatic attraction, and an insulating layer configured to cover an outer circumferential surface of the base, the supporter may have an insulating layer disposed at a support surface facing to the wafer transfer tray and in which a second conductive layer for electrostatic attraction is embedded, and a direct current voltage application unit configured to apply a direct current voltage may be connected to the base.

In the first aspect, the ground section may include a low-pass filter configured to cut an alternating current voltage having a predetermined frequency range applied to the supporter.

A wafer transfer tray of a plasma treatment apparatus according to a second aspect of the present invention includes a wafer transfer tray having a first surface and a second surface opposite to the first surface and configured to hold a wafer on the first surface; a cooling unit configured to cool the wafer transfer tray; a supporter configured to support the second surface of the wafer transfer tray and having a ground section setting a potential of the supporter to a ground potential with respect to a direct current voltage; and a conductor for electrostatic attraction connected to a direct current voltage application unit configured to apply a direct current voltage and embedded in the base.

### EFFECTS OF THE INVENTION

According to the plasma treatment apparatus and the wafer transfer tray according to the above-mentioned aspects of the present invention, the wafer and the supporter are electrostatically attracted by the double-surface electrostatic attractor of the plasma treatment apparatus at both of the first surface and the second surface of the wafer transfer tray.

Accordingly, when the plasma is generated between the supporter that forms the lower electrode and the upper electrode and plasma treatment is performed on the wafer, the wafer transfer tray can be efficiently and uniformly cooled. For this reason, the plasma treatment can be performed on the wafer uniformly and accurately.

In addition, the wafer transfer tray and the supporter closely contact with each other by electrostatically attracting the supporter to the wafer transfer tray. For this reason, the wafer transfer tray can be efficiently cooled by the cooling gas supplied from the gas supply unit. In addition, loss of the cooling gas due to dissipation can also be reduced by close contact between the wafer transfer tray and the supporter.

Then, for example, in comparison with the configuration in which the wafer transfer tray and the supporter are fixed by the mechanical clamp as in the related art, since the plasma treatment apparatus according to the present invention electrically attracts the wafer transfer tray and the supporter, a mechanical movable portion is reduced. Accordingly, the wafer transfer tray and the supporter can be easily fixed by a simple configuration.

### BRIEF DESCRIPTION OF THE DRAWINGS

Fig. 1 is a cross-sectional view showing a plasma treatment apparatus according to a first embodiment of the present invention as a whole.
Fig. 2 is a plan view of a wafer transfer tray according to the first embodiment of the present invention viewed from above.
Fig. 3 is a cross-sectional view showing a support section of a plasma treatment apparatus of a second embodiment of the present invention.
Fig. 4 is a cross-sectional view showing a support section of a plasma treatment apparatus of a third embodiment of the present invention.
Fig. 5 is a cross-sectional view showing a support section of a plasma treatment apparatus of a fourth embodiment of the present invention.
Fig. 6 is a cross-sectional view showing a support section of a plasma treatment apparatus of a fifth embodiment of the present invention.
Fig. 7 is a cross-sectional view showing a support section of a plasma treatment apparatus of a sixth embodiment of the present invention.
Fig. 8 is a cross-sectional view showing a support section of a plasma treatment apparatus of a seventh embodiment of the present invention.

### DETAILED DESCRIPTION OF THE INVENTION

Hereinafter, embodiments of a plasma treatment apparatus and a wafer transfer tray according to the present invention will be described with reference to the accompanying drawings. Further, the embodiments are provided to specifically describe the present invention such that the spirit of the present invention can be better understood, but are not intended to limit the present invention unless the context clearly indicates otherwise. In addition, in the drawings used in the following description, some parts may be exaggerated for clarity in order to clearly describe the present invention, and dimensions, ratios, and so on, of components are not limited to being the same as in reality.

### (First embodiment)

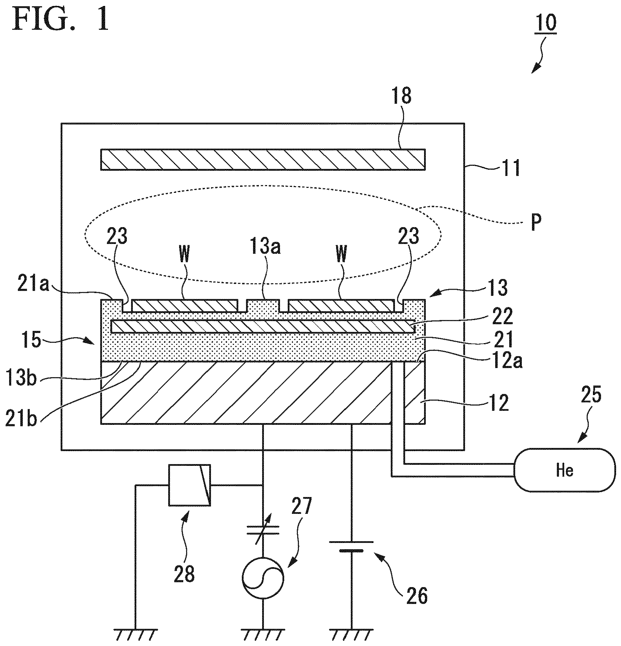

Fig. 1 is a cross-sectional view showing a plasma treatment apparatus according to a first embodiment of the present invention as a whole.
A plasma treatment apparatus 10 includes a plasma treatment tank (chamber) 11, an upper electrode 18 disposed in the vicinity of an upper surface in the plasma treatment tank 11, a supporter 12 disposed in the vicinity of a bottom surface in the plasma treatment tank 11 and configured to form a lower electrode, and a support section 15 having a wafer transfer tray 13 placed on the supporter 12.

The wafer transfer tray 13 has a substantially disk-shaped base 21, and a first conductive layer 22 for electrostatic attraction embedded at a position closer to one surface (a first surface) 21a than the other surface (a second surface) 21b of the base 21. In addition, a concave section 23 into which a wafer W serving as a substance to be treated is inserted is formed in the one surface 21a of the base 21.

The base 21 is constituted by a high resistance body having a resistance value of 10⁸ Ω or more and 10¹¹ Ω or less.

The high resistance body may be, for example, a ceramic plate, a resistance value of which is controlled.

In addition, the first conductive layer 22 is formed of a metal such as aluminum, tungsten or titanium, or an alloy including these metals. The first conductive layer 22 may be formed to be spread parallel to the one surface 21a of the base 21, for example, at a depth position of hundreds of micrometers to several millimeters from the one surface 21a of the base 21.

The above-mentioned wafer transfer tray 13 may be obtained by, for example, spraying a metal that constitutes the first conductive layer 22 onto a ceramic plate.

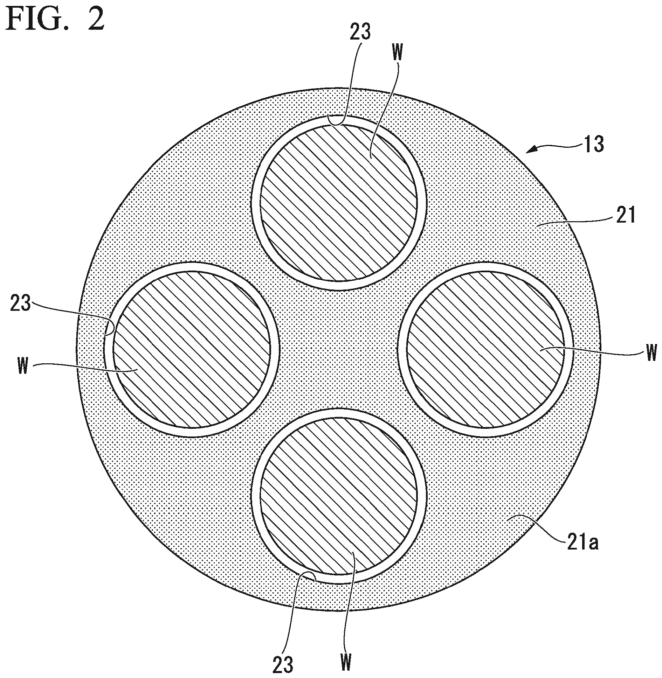

Fig. 2 is a plan view showing the wafer transfer tray 13 from an upper side. The wafer transfer tray 13 has a plurality of concave sections 23, 23 on which a plurality of wafers W having diameters of, for example, about 2 to 4 inches can be disposed. In the embodiment, four concave sections 23 are formed such that four wafers W can be placed thereon. Further, in order to efficiently perform plasma treatment of the wafers W, for example, about 5 to 30 concave sections 23 may be formed in the one surface 21a of the base 21.

Referring to Fig. 1 again, a gas supply unit 25 configured to supply a cooling gas and serving as a cooling unit configured to cool the wafer transfer tray 13 is connected to the support section 15. The cooling gas supplied from the gas supply unit 25 flows along, for example, a gas flow path (not shown) formed at one surface (a first surface) 13a side of the wafer transfer tray 13 to cool the wafer transfer tray 13. Further, when a structure in which a flow path is formed in the base 21 and a coolant flows through the flow path to cool the wafer transfer tray 13 is provided, cooling efficiency of the wafers can be further improved.

The cooling gas supplied from the gas supply unit 25 should be a gas that does not cause a chemical reaction with a plasma atmosphere P in the plasma treatment tank 11 and a laminated film or the like of the wafer W, and may be an inert gas. Further, in order to be used for control of a temperature increase, the inert gas may be helium gas having a low boiling point and a function as a coolant.

A direct current voltage application unit 26 configured to apply a direct current voltage is connected to the first conductive layer 22.

The direct current voltage application unit 26 is constituted by, for example, a direct current power supply apparatus, a connecting wiring, or the like. A direct current voltage applied to the first conductive layer 22 may be, for example, about 1000 V to 5000 V. The first conductive layer 22 is positively or negatively charged by applying direct current voltage.

The supporter 12 has a flat shape at least in a support surface 12a that comes in contact with the other surface (a second surface) 13b of the wafer transfer tray 13 to support the other surface, and supports the wafer transfer tray 13 at the support surface 12a. The entire supporter 12 is constituted by a conductor such as a metal or the like, for example, aluminum, titanium or iron, or an alloy including these metals.

A radio frequency voltage application unit 27 configured to apply a radio frequency voltage is connected to the supporter 12.

The radio frequency voltage application unit 27 is constituted by, for example, a radio frequency power supply apparatus, a connecting wiring, or the like. Accordingly, the supporter 12 functions as a lower electrode configured to generate the plasma P between the upper electrode 18 and the supporter 12.

In addition, a ground section 28 is connected to the supporter 12 so that the supporter 12 has a ground potential with respect to the direct current voltage. The ground section 28 is constituted by, for example, a low-pass filter, a grounding wiring, or the like. Among these, the low-pass filter cuts the radio frequency voltage applied by the radio frequency voltage application unit 27 and connects the supporter 12 to the grounding wiring with respect to only the direct current voltage. Accordingly, the supporter 12 has a ground potential with respect to the direct current voltage, and the radio frequency voltage applied by the radio frequency voltage application unit 27 flows to the ground section 28 and is not lost.

In the embodiment having the above-mentioned configuration, a double-surface electrostatic attractor is constituted by the base 21, the first conductive layer 22, the supporter 12, the direct current voltage application unit 26 and the ground section 28.

Actions of the plasma treatment apparatus and the wafer transfer tray having the above-mentioned configurations will be described.

In the plasma treatment apparatus 10 according to the embodiment, the first conductive layer 22 of the wafer transfer tray 13 is positively or negatively charged by applying the direct current voltage to the first conductive layer 22 using the direct current voltage application unit 26. Accordingly, the wafer W is electrostatically attracted to the wafer transfer tray 13 by a Coulomb's force (an electrostatic attractive force) generated by an electric charge induced between the wafer W placed on the concave section 23 of the wafer transfer tray 13 and the first conductive layer 22.

Meanwhile, the potential of the support body 12 becomes a ground potential with respect to the direct current voltage by the ground section 28. Then, since the base 21 that forms the wafer transfer tray 13 is constituted by a high resistance body having a resistance value of 10⁸ Ω or more and 10¹¹ Ω or less, conductivity is slightly applied to the base 21 and the wafer transfer tray 13 is electrostatically attracted to the supporter 12 by a Johnson-Labeque's force (an electrostatic attractive force) generated by electric charge movement in the base 21.

In this way, the wafer W and the supporter 12 are electrostatically attracted to both of the one surface 13a and the other surface 13b of the wafer transfer tray 13 by the double-surface electrostatic attractor of the plasma treatment apparatus 10, respectively. That is, the wafer W is electrostatically attracted to the one surface 13a of the wafer transfer tray 13 and the supporter 12 is electrostatically attracted to the other surface 13b of the wafer transfer tray 13.

Accordingly, when the plasma P is generated between the supporter 12 that forms the lower electrode and the upper electrode 18 and plasma treatment is performed on the wafer W, the wafer transfer tray can be efficiently and uniformly cooled, and the plasma treatment can be performed on the wafer W uniformly and accurately.

In addition, as the supporter 12 is electrostatically attracted to the wafer transfer tray 13, the wafer transfer tray 13 closely contacts with the supporter 12. For this reason, the wafer transfer tray 13 can be efficiently cooled by a cooling gas supplied from the gas supply unit 25. In addition, a loss of the cooling gas due to dissipation can be reduced by close contact between the wafer transfer tray 13 and the supporter 12.

Then, for example, in comparison with the configuration in which the wafer transfer tray and the supporter are fixed by the mechanical clamp as in the related art, since the plasma treatment apparatus 10 of the present invention electrically attracts the wafer transfer tray and the supporter, a mechanical movable portion is reduced. Accordingly, the wafer transfer tray and the supporter can be easily fixed by a simple configuration.

Further, in the above-mentioned embodiment, while the first conductive layer 22 is shown as an example of a monopole type, a bipolar type in which a plurality of conductive layers have different polarities may be provided.

Hereinafter, another embodiment of the plasma treatment apparatus of the present invention will be described. In the following embodiments, only configurations and actions of portions related to the wafer transfer tray and the supporter will be described. The other configurations are the same as the above-mentioned first embodiment. In addition, the same members as the above-mentioned first embodiment are designated by the same reference numerals, and a detailed description of the configurations will be omitted.

### (Second embodiment)

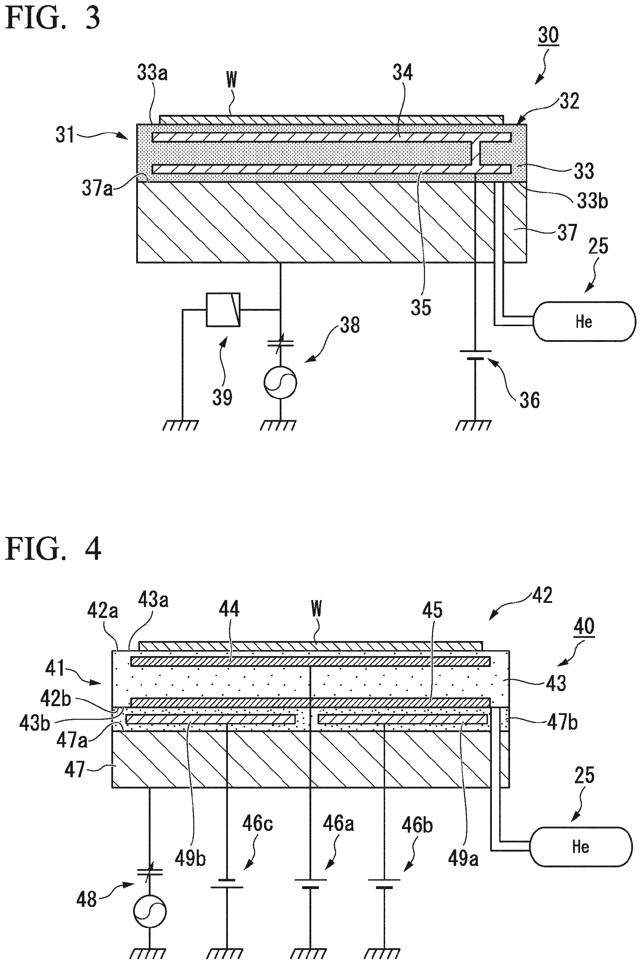

Fig. 3 is a cross-sectional view showing the vicinity of a support section of a plasma treatment apparatus according to a second embodiment of the present invention. A wafer transfer tray 32 in a support section 31 of a plasma treatment apparatus 30 according to the second embodiment has a base 33 formed of an insulating body, a first conductive layer 34 for electrostatic attraction embedded at a position closer to one surface (a first surface) 33a than the other surface 33b of the base 33, and a second conductive layer 35 for electrostatic attraction embedded at a position closer to the other surface (a second surface) 33b than the one surface 33a of the base 33.

The base 33 is constituted by, a for example, a ceramic plate or the like. The first conductive layer 34 and the second conductive layer 35 are electrically connected by a conductor extending in a thickness direction of the wafer transfer tray 32.

The first conductive layer 34 and the second conductive layer 35 are formed of a metal, such as, for example, aluminum, tungsten or titanium, or an alloy including these metals. The first conductive layer 34 may be formed to spread parallel to the one surface 33a of the base 33 at, for example, a depth position of hundreds of micrometers from the one surface 33a of the base 33. In addition, the second conductive layer 35 may be formed to spread parallel to the other surface 33b of the base 33 at, for example, a depth position of hundreds of micrometers from the other surface 33b of the base 33.

The above-mentioned wafer transfer tray 32 can be obtained by, for example, spraying a metal that constitutes the first conductive layer 33 and the second conductive layer 34 onto the ceramic plate.

The gas supply unit 25 configured to supply a cooling gas and serving as a cooling unit configured to cool the wafer transfer tray 32 is connected to the support section 31. The cooling gas supplied from the gas supply unit 25 flows along a gas flow path (not shown) formed at, for example, one surface (a first surface) 32a side of the wafer transfer tray 32 to cool the wafer transfer tray 32.

A direct current voltage application unit 36 configured to apply a direct current voltage is connected to the first conductive layer 34 and the second conductive layer 35. The direct current voltage application unit 36 is constituted by, for example, a direct current power supply apparatus, a connecting wiring, or the like. The first conductive layer 34 and the second conductive layer 35 are positively or negatively charged by application of the above-mentioned direct current voltage.

A supporter 37 has a flat shape at least in a support surface 37a that comes in contact with the other surface (a second surface) 32b of the wafer transfer tray 32 and supports the other surface 32b , and supports the wafer transfer tray 32 at the support surface 37a. The entire supporter 37 is constituted by a conductor such as a metal or the like, such as, for example, aluminum, titanium or iron, or an alloy including these metals.

A radio frequency voltage application unit 38 configured to apply a radio frequency voltage is connected to the supporter 37.

The radio frequency voltage application unit 38 is constituted by, for example, a radio frequency power supply apparatus, a connecting wiring, or the like. Accordingly, the supporter 37 functions as a lower electrode configured to generate the plasma P between the upper electrode 18 (see Fig. 1) and the supporter 37.

In addition, a ground section 39 is connected to the supporter 37 so that the supporter 37 has a ground potential with respect to the direct current voltage. The ground section 39 is constituted by, for example, a low-pass filter, a grounding wiring, or the like. Among these, the low-pass filter cuts the radio frequency voltage applied by the radio frequency voltage application unit 38 and connects the supporter 37 to the grounding wiring with respect to only the direct current voltage. Accordingly, the supporter 37 has a ground potential with respect to the direct current voltage, and the radio frequency voltage applied by the radio frequency voltage application unit 38 flows to the ground section 39 and is not lost.

In the embodiment having the above-mentioned configuration, a double-surface electrostatic attractor is constituted by the base 33, the first conductive layer 34, the second conductive layer 35, the supporter 37, the direct current voltage application unit 36 and the ground section 39.

Actions of the plasma treatment apparatus and the wafer transfer tray according to the second embodiment having the above-mentioned configuration will be described. In the plasma treatment apparatus 30 according to the embodiment, as the direct current voltage is applied to the first conductive layer 34 by the direct current voltage application unit 36, the first conductive layer 34 of the wafer transfer tray 32 is positively or negatively charged. Accordingly, the wafer W is electrostatically attracted to the wafer transfer tray 32 by a Coulomb's force (an electrostatic attractive force) generated by electric charges induced between the wafer W placed on the wafer transfer tray 32 and the first conductive layer 34.

Meanwhile, the potential of the support body 37 becomes a ground potential with respect to the direct current voltage by the ground section 39. Then, as the direct current voltage is applied to the second conductive layer 35 by the direct current voltage application unit 36, the second conductive layer 35 of the wafer transfer tray 32 is positively or negatively charged. Accordingly, the supporter 37 is electrostatically attracted to the wafer transfer tray 32 by a Coulomb's force (an electrostatic attractive force) generated by electric charges induced between the support surface 37a of the supporter 37 and the second conductive layer 35.

In this way, the wafer W and the supporter 37 are electrostatically attracted by the double-surface electrostatic attractor of the plasma treatment apparatus 30 at both of the one surface 32a and the other surface 32b of the wafer transfer tray 32, respectively. That is, the wafer W is electrostatically attracted to the one surface 32a of the wafer transfer tray 32 and the supporter 37 is electrostatically attracted to the second surface 32b of the wafer transfer tray 32.

Accordingly, when the plasma P is generated between the supporter 37 that forms the lower electrode and the upper electrode 18 (see Fig. 1) and plasma treatment is performed on the wafer W, the wafer transfer tray can be efficiently and uniformly cooled and the plasma treatment can be performed on the wafer W uniformly and accurately.

In addition, the wafer transfer tray 32 and the supporter 37 closely contact with each other by electrostatically attracting the supporter 37 to the wafer transfer tray 32. For this reason, the wafer transfer tray 32 can be efficiently cooled by the cooling gas supplied from the gas supply unit 25. In addition, loss of the cooling gas due to dissipation can be reduced by close contact of the wafer transfer tray 32 and the supporter 37.

Then, for example, in comparison with the configuration in which the wafer transfer tray and the supporter are fixed by the mechanical clamp as in the related art, since the plasma treatment apparatus 30 according to the embodiment can electrically attract the wafer transfer tray and the supporter, a mechanical movable portion is reduced. Accordingly, the wafer transfer tray and the supporter can be easily fixed by a simple configuration.

### (Third embodiment)

Fig. 4 is a cross-sectional view showing the vicinity of a support section of a plasma treatment apparatus according to a third embodiment of the present invention. A wafer transfer tray 42 in a support section 41 of a plasma treatment apparatus 40 according to the third embodiment has a base 43 formed of an insulating body, a first conductive layer 44 for electrostatic attraction embedded at a position closer to one surface (a first surface) 43a than the other surface 43b of the base 43, and a conductor 45 disposed to be exposed at the other surface (a second surface) 43b of the base 43.

The base 43 is constituted by, for example, a ceramic plate or the like. The first conductive layer 44 and the conductor 45 are formed of a metal, for example, aluminum, tungsten or titanium, or an alloy including these metals. The first conductive layer 44 may be formed to spread parallel to the one surface 43a of the base 43 at, for example, a depth position of several millimeters from the one surface 43a of the base 43.

The above-mentioned wafer transfer tray 42 can be obtained by, for example, spraying the metal that constitutes the first conductive layer 43 onto the ceramic plate.

The gas supply unit 25 configured to supply a cooling gas and serving as a cooling unit configured to cool the wafer transfer tray 42 is connected to the support section 41. The cooling gas supplied from the gas supply unit 25 flows along, for example, a gas flow path (not shown) formed at one surface (a first surface) 42a side of the wafer transfer tray 42 to cool the wafer transfer tray 42.

A direct current voltage application unit 46a configured to apply a direct current voltage is connected to the first conductive layer 44. The direct current voltage application unit 46a is constituted by, for example, a direct current power supply apparatus, a connecting wiring, or the like. The first conductive layer 44 is positively or negatively charged by applying direct current voltage.

An insulating layer 47b in which second conductive layers 49a and 49b for electrostatic attraction are embedded are formed at a support surface 47a of a supporter 47 that comes in contact with the other surface (a second surface) 42b of the wafer transfer tray 42 to support the wafer transfer tray 42. The entire second conductive layers 49a and 49b are constituted by a conductor of a metal or the like, for example, aluminum, titanium or iron, or an alloy including these metals. In addition, the insulating layer 47b is formed of, for example, a ceramic.

A direct current voltage application unit 46b and a direct current voltage application unit 46c configured to apply a direct current voltage are connected to the second conductive layer 49a and the second conductive layer 49b, respectively. The direct current voltage application units 46b and 46c are constituted by, for example, a direct current power supply apparatus, a connecting wiring, or the like. The second conductive layers 49a and 49b are charged to polarities that are opposite to each other, and form a bipolar type electrostatic attractor.

A radio frequency voltage application unit 48 configured to apply a radio frequency voltage is connected to the supporter 47.
The radio frequency voltage application unit 48 is constituted by, for example, a radio frequency power supply apparatus, a connecting wiring, or the like. Accordingly, the supporter 47 functions as a lower electrode configured to generate the plasma P between the upper electrode 18 (see Fig. 1) and the supporter 47.

In the embodiment having the above-mentioned configuration, a double-surface electrostatic attractor is constituted by the base 43, the first conductive layer 44, the conductor 45, the second conductive layers 49a and 49b, and the direct current voltage application units 46a, 46b and 46c.

Actions of the plasma treatment apparatus and the wafer transfer tray according to the third embodiment having the above-mentioned configuration will be described. In the plasma treatment apparatus 40 according to the embodiment, as the direct current voltage is applied to the first conductive layer 44 by the direct current voltage application unit 46a, the first conductive layer 44 of the wafer transfer tray 42 is positively or negatively charged. Accordingly, the wafer W is electrostatically attracted to the wafer transfer tray 42 by a Coulomb's force (an electrostatic attractive force) generated by electric charges induced between the wafer W placed on the wafer transfer tray 42 and the first conductive layer 44.

Meanwhile, direct current voltages having opposite polarities are applied from the direct current voltage application units 46b and 46c to the second conductive layers 49a and 49b embedded in the insulating layer 47b formed on the supporter 47. Accordingly, the supporter 47 is electrostatically attracted to the wafer transfer tray 42 by a Coulomb's force (an electrostatic attractive force) generated by electric charges induced between the conductor 45 formed on the other surface 42b of the wafer transfer tray 42 and the second conductive layers 49a and 49b.

In this way, the wafer W and the supporter 47 are electrostatically attracted by the double-surface electrostatic attractor of the plasma treatment apparatus 40 at both of the one surface 42a and the other surface 42b of the wafer transfer tray 42, respectively. That is, the wafer W is electrostatically attracted to the one surface 42a of the wafer transfer tray 42 and the supporter 47 is electrostatically attracted to the other surface 42b of the wafer transfer tray 42.

Accordingly, when the plasma P is generated between the supporter 47 that forms a lower electrode and the upper electrode 18 (see Fig. 1) and plasma treatment is performed on the wafer W, the wafer transfer tray can be efficiently and uniformly cooled and the plasma treatment can be performed on the wafer W uniformly and accurately.

In addition, the wafer transfer tray 42 and the supporter 47 closely contact with each other by electrostatically attracting the supporter 47 to the wafer transfer tray 42. For this reason, the wafer transfer tray 42 can be efficiently cooled by the cooling gas supplied from the gas supply unit 25. In addition, loss of the cooling gas due to dissipation can be reduced by close contact between the wafer transfer tray 42 and the supporter 47.

Then, for example, in comparison with the case in which the wafer transfer tray and the supporter are fixed by the mechanical clamp as in the related art, since the plasma treatment apparatus 40 according to the embodiment electrically attracts the wafer transfer tray and the supporter, a mechanical movable portion is reduced. Accordingly, the wafer transfer tray and the supporter can be easily fixed by a simple configuration .

### (Fourth embodiment)

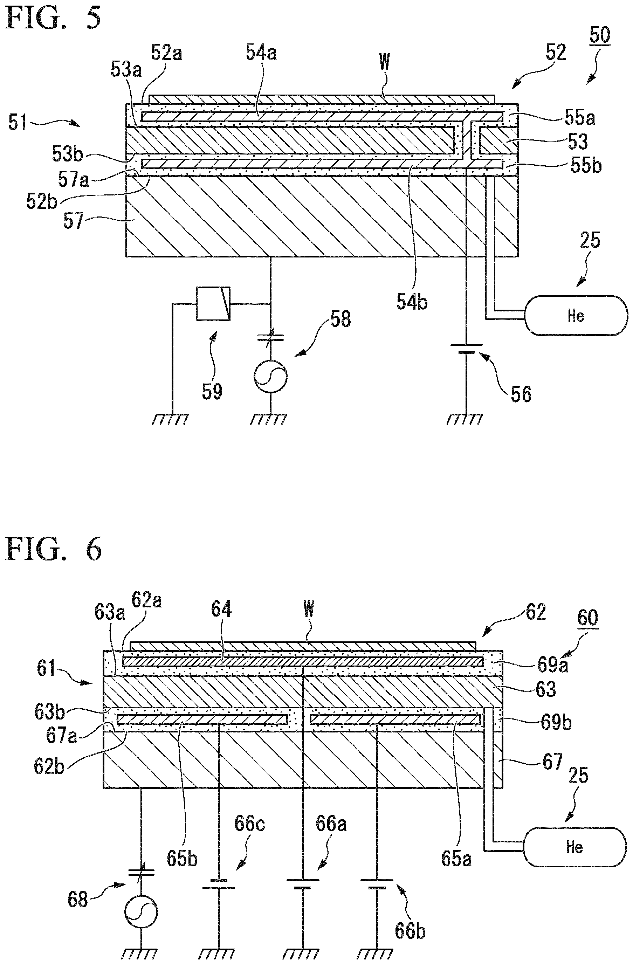

Fig. 5 is a cross-sectional view showing the vicinity of a support section of a plasma treatment apparatus according to a fourth embodiment of the present invention. A wafer transfer tray 52 in a support section 51 of a plasma treatment apparatus 50 of the fourth embodiment has a base 53 formed of a metal, a first insulating layer 55a formed on one surface (a first surface) 53a of the base 53 and in which a first conductive layer 54a is embedded, and a second insulating layer 55b formed on the other surface (a second surface) 53b of the base 53 and in which a second conductive layer 54b is embedded.

The base 53 is formed of a metal, for example, aluminum, titanium or iron, or an alloy including these metals. The first conductive layer 54a and the second conductive layer 54b are electrically connected by a conductor extending in a thickness direction of the wafer transfer tray 52. In addition, the conductor configured to electrically connect the first conductive layer 54a and the second conductive layer 54b is also coated with an insulating body to be insulated from the base 53. The first conductive layer 54a and the second conductive layer 54b are formed of a metal such as aluminum, tungsten or titanium, or an alloy including these metals. The first insulating layer 55a and the second insulating layer 55b are formed of, for example, a ceramic.

The gas supply unit 25 configured to supply a cooling gas and serving as a cooling unit configured to cool the wafer transfer tray 52 is connected to the support section 51. The cooling gas supplied from the gas supply unit 25 flows along, for example, a gas flow path (not shown) formed at one surface (a first surface) 52a side of the wafer transfer tray 52 to cool the wafer transfer tray 52.

A direct current voltage application unit 56 configured to apply a direct current voltage is connected to the first conductive layer 54a and the second conductive layer 54b. The direct current voltage application unit 56 is constituted by, for example, a direct current power supply apparatus, a connecting wiring, or the like. The first conductive layer 54a and the second conductive layer 54b are positively or negatively charged by application of the above-mentioned direct current voltage.

A supporter 57 has a flat shape in a support surface 57a configured to come in contact with at least the other surface (a second surface) 52b of the wafer transfer tray 52 to support the wafer transfer tray 52, and supports the wafer transfer tray 52 at the support surface 57a. The entire supporter 57 is constituted by a conductor formed of a metal or the like, for example, aluminum, titanium or iron, or an alloy including these metals.

A radio frequency voltage application unit 58 configured to apply a radio frequency voltage is connected to the supporter 57.

The radio frequency voltage application unit 58 is constituted by, for example, a radio frequency power supply apparatus, a connecting wiring, or the like. Accordingly, the supporter 57 functions as a lower electrode configured to generate the plasma P between the upper electrode 18 (see Fig. 1) and the supporter 57.

In addition, a ground section 59 is connected to the supporter 57 so that the supporter 57 has a ground potential with respect to the direct current voltage. The ground section 59 is constituted by, for example, a low-pass filter, a grounding wiring, or the like. Among these, the low-pass filter cuts a radio frequency voltage applied by the radio frequency voltage application unit 58, and connects the supporter 57 to the grounding wiring with respect to only the direct current voltage. Accordingly, the supporter 57 has a ground potential with respect to the direct current voltage, and a radio frequency voltage applied by the radio frequency voltage application unit 58 flows to the ground section 59 and is not lost.

In the embodiment having the above-mentioned configuration, a double-surface electrostatic attractor is constituted by the first insulating layer 55a in which the first conductive layer 54a is embedded, the second insulating layer 55b in which the second conductive layer 54b is embedded, the supporter 57, the direct current voltage application unit 56 and the ground section 59.

Actions of the plasma treatment apparatus and the wafer transfer tray according to the fourth embodiment having the above-mentioned configuration will be described. In the plasma treatment apparatus 50 according to the embodiment, as the direct current voltage is applied to the first conductive layer 54a by the direct current voltage application unit 56, the first conductive layer 54a of the wafer transfer tray 52 is positively or negatively charged. Accordingly, the wafer W is electrostatically attracted to the wafer transfer tray 52 by a Coulomb's force (an electrostatic attractive force) generated by electric charges induced between the wafer W placed on the wafer transfer tray 52 and the first conductive layer 54a.

Meanwhile, the potential of the support body 57 becomes a ground potential with respect to the direct current voltage by the ground section 59. Then, as the direct current voltage is applied to the second conductive layer 54b by the direct current voltage application unit 56, the second conductive layer 54b of the wafer transfer tray 52 is positively or negatively charged. Accordingly, the supporter 57 is electrostatically attracted to the wafer transfer tray 52 by a Coulomb's force (an electrostatic attractive force) generated by electric charges induced between the support surface 57a of the supporter 57 and the second conductive layer 54b.

In this way, the wafer W and the supporter 57 are electrostatically attracted by the double-surface electrostatic attractor of the plasma treatment apparatus 50 at both of the one surface 52a and the other surface 52b of the wafer transfer tray 52, respectively. That is, the wafer W is electrostatically attracted to the one surface 52a of the wafer transfer tray 52 and the supporter 57 is electrostatically attracted to the other surface 52b of the wafer transfer tray 52.

Accordingly, when the plasma P is generated between the supporter 57 that forms the lower electrode and the upper electrode 18 (see Fig. 1) and plasma treatment is performed on the wafer W, the wafer transfer tray can be efficiently and uniformly cooled and the plasma treatment can be performed on the wafer W uniformly and accurately.

In addition, since the wafer transfer tray 52 and the supporter 57 closely contact with each other by electrostatically attracting the supporter 57 to the wafer transfer tray 52, the wafer transfer tray 52 can be efficiently cooled by the cooling gas supplied from the gas supply unit 25. In addition, loss of the cooling gas due to dissipation can be reduced by close contact between the wafer transfer tray 52 and the supporter 57.

Then, for example, in comparison with the configuration in which the wafer transfer tray and the supporter are fixed by the mechanical clamp as in the related art, since the plasma treatment apparatus 50 according to the embodiment electrically attracts the wafer transfer tray and the supporter, a mechanical movable portion is reduced. Accordingly, the wafer transfer tray and the supporter can be easily fixed by a simple configuration.

### (Fifth embodiment)

Fig. 6 is a cross-sectional view showing the vicinity of a support section of a plasma treatment apparatus according to a fifth embodiment of the present invention. A wafer transfer tray 62 in a support section 61 of a plasma treatment apparatus 60 according to the fifth embodiment has a base 63 formed of a metal, and a first insulating layer 69a formed on one surface (a first surface) 63a of the base 63 and in which a first conductive layer 64 is embedded.

The base 63 is formed of a metal such as aluminum, titanium or iron, or an alloy including these metals. The first conductive layer 64 is formed of a metal such as aluminum, tungsten or titanium, or an alloy including these metals. The first insulating layer 69a is formed of, for example, a ceramic.

The gas supply unit 25 configured to supply a cooling gas and serving as a cooling unit configured to cool the wafer transfer tray 62 is connected to the support section 61. The cooling gas supplied from the gas supply unit 25 flows to, for example, a gas flow path (not shown) formed at one surface (a first surface) 62a side of the wafer transfer tray 62 to cool the wafer transfer tray 62.

A direct current voltage application unit 66a configured to apply a direct current voltage is connected to the first conductive layer 64. The direct current voltage application unit 66a is constituted by, for example, a direct current power supply apparatus, a connecting wiring, or the like. The first conductive layer 64 is positively or negatively charged by application of the above-mentioned direct current voltage.

A second insulating layer 69b in which second conductive layers 65a and 65b for electrostatic attraction are embedded is formed on a support surface 67a of a supporter 67 configured to come in contact with the other surface (a second surface) 62b of the wafer transfer tray 62 to support the wafer transfer tray 62. The entire second conductive layers 65a and 65b are constituted by a conductor of a metal or the like, for example, aluminum, tungsten or titanium, or an alloy including these metals. In addition, the second insulating layer 69b is constituted by, for example, a ceramic.

A direct current voltage application unit 66b and a direct current voltage application unit 66c configured to apply a direct current voltage are connected to the second conductive layer 65a and the second conductive layer 65b, respectively. The direct current voltage application units 66b and 66c are constituted by, for example, a direct current power supply apparatus and a connecting wiring, or the like. The second conductive layers 65a and 65b are charged with polarities that are opposite to each other, and form a bipolar type electrostatic attractor.

A radio frequency voltage application unit 68 configured to apply a radio frequency voltage is connected to the supporter 67.
The radio frequency voltage application unit 68 is constituted by, for example, a radio frequency power supply apparatus, a connecting wiring, or the like. Accordingly, the supporter 67 functions as a lower electrode configured to generate the plasma P between the upper electrode 18 (see Fig. 1) and the supporter 67.

In the embodiment having the above-mentioned configuration, a double-surface electrostatic attractor is constituted by the first insulating layer 69a in which the first conductive layer 64 is embedded, the second insulating layer 69b in which the second conductive layers 65a and 65b are embedded, the supporter 67, and the direct current voltage application units 66a, 66b and 66c.

Actions of the plasma treatment apparatus and wafer transfer tray according to the fifth embodiment having the above-mentioned configuration will be described. In the plasma treatment apparatus 60 according to the embodiment, as the direct current voltage is applied to the first conductive layer 64 by the direct current voltage application unit 66a, the first conductive layer 64 of the wafer transfer tray 62 is positively or negatively charged. Accordingly, the wafer W is electrostatically attracted to the wafer transfer tray 62 by a Coulomb's force (an electrostatic attractive force) generated by electric charges induced between the wafer W placed on the wafer transfer tray 62 and the first conductive layer 64.

Meanwhile, as direct current voltages having polarities that are opposite to each other are applied from the direct current voltage application units 66b and 66c with respect to the second conductive layers 65a and 65b embedded in the second insulating layer 69b formed on the supporter 67, the supporter 67 is electrostatically attracted to the wafer transfer tray 62.

In this way, the wafer W and the supporter 67 are electrostatically attracted by the double-surface electrostatic attractor of the plasma treatment apparatus 60 at both of one surface 62a and the other surface 62b of the wafer transfer tray 62, respectively. That is, the wafer W is electrostatically attracted to the one surface 62a of the wafer transfer tray 62 and the supporter 67 is electrostatically attracted to the other surface 62b of the wafer transfer tray 62.

Accordingly, when the plasma P is generated between the supporter 67 that forms the lower electrode and the upper electrode 18 (see Fig. 1) and plasma treatment is performed on the wafer W, since the wafer transfer tray can be efficiently and uniformly cooled, the plasma treatment can be performed on the wafer W uniformly and accurately.

In addition, the wafer transfer tray 62 and the supporter 67 closely contact with each other by electrostatically attracting the supporter 67 to the wafer transfer tray 62. For this reason, the wafer transfer tray 62 can be efficiently cooled by the cooling gas supplied from the gas supply unit 25. In addition, loss of the cooling gas due to dissipation can be reduced by close contact between the wafer transfer tray 62 and the supporter 67.

Then, for example, in comparison with the configuration in which the wafer transfer tray and the supporter are fixed by the mechanical clamp as in the related art, since the plasma treatment apparatus 60 according to the embodiment electrically attracts the supporter to the wafer transfer tray, a mechanical movable portion is reduced. Accordingly, the wafer transfer tray and the supporter can be easily fixed by a simple configuration.

### (Sixth embodiment)

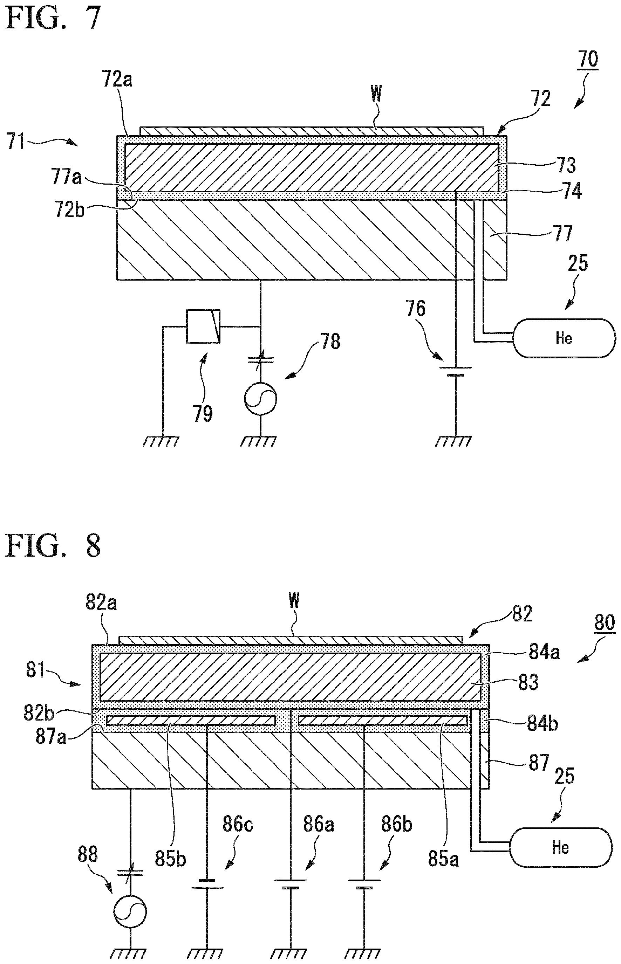

Fig. 7 is a cross-sectional view showing the vicinity of a support section of a plasma treatment apparatus according to a sixth embodiment of the present invention. A wafer transfer tray 72 in a support section 71 of a plasma treatment apparatus 70 of the sixth embodiment has a base 73 formed of a metal, and an insulating layer 74 configured to cover an outer circumferential surface of the base 73.

The base 73 is formed of a metal such as aluminum, titanium or iron, or an alloy including these metals. The insulating layer 74 is formed of, for example, a ceramic.

The gas supply unit 25 configured to supply a cooling gas and serving as a cooling unit configured to cool the wafer transfer tray 72 is connected to the support section 71. The cooling gas supplied from the gas supply unit 25 flows to, for example, a gas flow path (not shown) formed at a first surface (a first surface) 72a side of the wafer transfer tray 72 to cool the wafer transfer tray 72.

A direct current voltage application unit 76 configured to apply a direct current voltage is connected to the base 73 formed of a metal. The direct current voltage application unit 76 is constituted by, for example, a direct current power supply apparatus, a connecting wiring, or the like.

The base 73 is positively or negatively charged by application of the above-mentioned direct current voltage.

A supporter 77 has a flat shape in a support surface 77a configured to come in contact with at least the other surface (a second surface) 72b of the wafer transfer tray 72 to support the wafer transfer tray 72, and supports the wafer transfer tray 72 at the support surface 77a. The entire supporter 77 is constituted by a conductor of a metal or the like, for example, aluminum, titanium, iron or copper, or an alloy including these metals.

A radio frequency voltage application unit 78 configured to apply a radio frequency voltage is connected to the supporter 77.

The radio frequency voltage application unit 78 is constituted by, for example, a radio frequency power supply apparatus, a connecting wiring, and so on. Accordingly, the supporter 77 functions as a lower electrode configured to generate the plasma P between the upper electrode 18 (see Fig. 1) and the supporter 77.

In addition, a ground section 79 is connected to the supporter 77 so that the supporter 77 has a ground potential with respect to the direct current voltage. The ground section 79 is constituted by, for example, a low-pass filter, a grounding wiring, or the like. Among these, the low-pass filter cuts a radio frequency voltage applied by the radio frequency voltage application unit 78, and connects the supporter 77 to the grounding wiring with respect to only the direct current voltage. Accordingly, the supporter 77 has a ground potential with respect to the direct current voltage, and the radio frequency voltage applied by the radio frequency voltage application unit 78 flows to the ground section 79 and is not lost.

In the embodiment having the above-mentioned configuration, a double-surface electrostatic attractor is constituted by the base 73 formed of a metal, the supporter 77, the direct current voltage application unit 76 and the ground section 79.

Actions of the plasma treatment apparatus and the wafer transfer tray according to the sixth embodiment having the above-mentioned configuration will be described. In the plasma treatment apparatus 70 according to the embodiment, as the direct current voltage is applied to the base 73 formed of a metal by the direct current voltage application unit 76, the base 73 of the wafer transfer tray 52 is positively or negatively charged. Accordingly, the wafer W is electrostatically attracted to the wafer transfer tray 72 by a Coulomb's force (an electrostatic attractive force) generated by electric charges induced between the wafer W placed on the wafer transfer tray 72 and the base 73.

Meanwhile, the potential of the support body 57 becomes the ground potential with respect to the direct current voltage by the ground section 59. Then, as the direct current voltage is applied to the base 73 by the direct current voltage application unit 56, the base 73 of the wafer transfer tray 72 is positively or negatively charged.

Accordingly, the supporter 77 is electrostatically attracted to the wafer transfer tray 72 by a Coulomb's force (an electrostatic attractive force) generated by electric charges induced between the support surface 77a of the supporter 77 and the base 73.

In this way, the wafer W and the supporter 77 are electrostatically attracted by the double-surface electrostatic attractor of the plasma treatment apparatus 70 at both of one surface 72a and the other surface 72b of the wafer transfer tray 72, respectively. That is, the wafer W is electrostatically attracted to the one surface 72a of the wafer transfer tray 72 and the supporter 77 is electrostatically attracted to the other surface 72b of the wafer transfer tray 72.

Accordingly, when the plasma P is generated between the supporter 77 that forms the lower electrode and the upper electrode 18 (see Fig. 1) and plasma treatment is performed on the wafer W, since the wafer transfer tray can be efficiently and uniformly cooled, the plasma treatment can be performed on the wafer W uniformly and accurately.

In addition, the wafer transfer tray 72 and the supporter 77 closely contact with each other by electrostatically attracting the supporter 77 to the wafer transfer tray 72. For this reason, the wafer transfer tray 72 can be efficiently cooled by the cooling gas supplied from the gas supply unit 25. In addition, loss of the cooling gas due to dissipation can also be reduced by close contact between the wafer transfer tray 72 and the supporter 77.

Then, for example, in comparison with the configuration in which the wafer transfer tray and the supporter are fixed by the mechanical clamp as in the related art, since the plasma treatment apparatus 70 of the present invention electrically attracts the wafer transfer tray and the supporter, a mechanical movable portion is reduced. Accordingly, the wafer transfer tray and the supporter can be easily fixed by a simple configuration.

### (Seventh embodiment)

Fig. 8 is a cross-sectional view showing the vicinity of a support section of a plasma treatment apparatus according to a seventh embodiment of the present invention. A wafer transfer tray 82 in a support section 81 of a plasma treatment apparatus 80 of the seventh embodiment has a base 83 formed of a metal, and a first insulating layer 84a configured to cover an outer circumferential surface of the base 83.

The base 83 is formed of a metal such as aluminum, titanium or iron, or an alloy including these metals. The first insulating layer 84a is formed of, for example, a ceramic.

The gas supply unit 25 configured to supply a cooling gas and serving as a cooling unit configured to cool the wafer transfer tray 82 is connected to the support section 81. The cooling gas supplied from the gas supply unit 25 flows to, for example, a gas flow path (not shown) formed at one surface (a first surface) 82a side of the wafer transfer tray 82 to cool the wafer transfer tray 82.

A direct current voltage application unit 86a configured to apply a direct current voltage is connected to the base 83 formed of a metal. The direct current voltage application unit 86a is constituted by, for example, a direct current power supply apparatus, a connecting wiring, or the like. The base 83 is positively or negatively charged by application of the above-mentioned direct current voltage.

A second insulating layer 84b in which second conductive layers 85a and 85b for electrostatic attraction are embedded is formed on a support surface 87a of a supporter 87 configured to come in contact with the other surface (a second surface) 82b of the wafer transfer tray 82 to support the wafer transfer tray 82. The entire second conductive layers 85a and 85b are constituted by a conductor of a metal or the like, for example, aluminum, tungsten or titanium, or an alloy including these metals. In addition, the second insulating layer 84b is formed of, for example, a ceramic.

A direct current voltage application unit 86b and a direct current voltage application unit 86c configured to apply a direct current voltage are connected to the second conductive layer 85a and the second conductive layer 85b, respectively. The direct current voltage application units 86b and 86c are constituted by, for example, a direct current power supply apparatus, a connecting wiring, or the like. The second conductive layers 85a and 85b are charged with polarities that are opposite to each other, and form a bipolar type electrostatic attractor.

A radio frequency voltage application unit 88 configured to apply a radio frequency voltage is connected to the supporter 87.

The radio frequency voltage application unit 88 is constituted by, for example, a radio frequency power supply apparatus, a connecting wiring, or the like. Accordingly, the supporter 87 functions as a lower electrode configured to generate the plasma P between the upper electrode 18 (see Fig. 1) and the supporter 87.

In the embodiment having the above-mentioned configuration, a double-surface electrostatic attractor is constituted by the base 83 formed of a metal, the supporter 87, the second insulating layer 84b in which the second conductive layers 85a and 85b are embedded, and the direct current voltage application units 86a, 86b and 86c.

Actions of the plasma treatment apparatus and the wafer transfer tray according to the seventh embodiment having the above-mentioned configuration will be described. In the plasma treatment apparatus 80 according to the embodiment, as the direct current voltage is applied to the base 83 formed of a metal by the direct current voltage application unit 86a, the base 83 of the wafer transfer tray 82 is positively or negatively charged. Accordingly, the wafer W is electrostatically attracted to the wafer transfer tray 82 by a Coulomb's force (an electrostatic attractive force) generated by electric charges induced between the wafer W placed on the wafer transfer tray 82 and the base 83.

Meanwhile, as the direct current voltages having polarities that are opposite to each other are applied from the direct current voltage application units 86b and 86c with respect to the second conductive layers 85a and 85b embedded in the second insulating layer 84b formed on the supporter 87, the supporter 87 is electrostatically attracted to the wafer transfer tray 82.

In this way, the wafer W and the supporter 87 are electrostatically attracted by the double-surface electrostatic attractor of the plasma treatment apparatus 80 at both of the one surface 82a and the other surface 82b of the wafer transfer tray 82, respectively. That is, the wafer W is electrostatically attracted to the one surface 82a of the wafer transfer tray 82 and the supporter 87 is electrostatically attracted to the other surface 82b of the wafer transfer tray 82.

Accordingly, when the plasma P is generated between the supporter 87 that forms the lower electrode and the upper electrode 18 (see Fig. 1) and plasma treatment is performed on the wafer W, since the wafer transfer tray can be efficiently and uniformly cooled, the plasma treatment can be performed on the wafer W uniformly and accurately.

In addition, the wafer transfer tray 82 and the supporter 87 closely contact with each other by electrostatically attracting the supporter 87 to the wafer transfer tray 82. For this reason, the wafer transfer tray 82 can be efficiently cooled by the cooling gas supplied from the gas supply unit 25. In addition, loss of the cooling gas due to dissipation can also be reduced by close contact between the wafer transfer tray 82 and the supporter 87.

Then, for example, in comparison with the configuration in which the wafer transfer tray and the supporter are fixed by the mechanical clamp as in the related art, since the plasma treatment apparatus 80 according to the embodiment electrically attracts the wafer transfer tray and the supporter, a mechanical movable portion is reduced. Accordingly, the wafer transfer tray and the supporter can be easily fixed by a simple configuration.

### DESCRIPTION OF REFERENCE NUMERAL

10 Plasma treatment apparatus 12 Supporter 13 Wafer transfer tray 21 Base 22 First conductive layer 26 Direct current voltage application unit 28 Ground section

## Claims

1. A plasma treatment apparatus (10) comprising:
a wafer transfer tray (13) having a first surface and a second surface opposite to the first surface, and configured to hold a wafer (W) on the first surface;
a cooling unit (25) configured to cool the wafer transfer tray (13);
a conductive supporter (12) configured to support the second surface of the wafer transfer tray (13); and
a double-surface electrostatic attractor (21, 22) configured to monopolarly-electrostatically attract the wafer (W) to the first surface of the wafer transfer tray (13) and to monopolarly-electrostatically attract the supporter (12) to the second surface of the wafer transfer tray (13), the double-surface electrostatic attractor (21, 22) comprising a conductive member formed of a conductive layer (22) or a conductor, wherein
the conductive member and the supporter (12) are attracted to each other via an insulating laver,
a direct current voltage application unit (26) configured to apply a direct current voltage is connected to the double-surface electrostatic attractor (21, 22) and
a ground section (28) is connected to the supporter (12) such that the supporter (12) has a ground potential with respect to the direct current voltage.

2. The plasma treatment apparatus according to claim 1, wherein a radio frequency voltage application unit is connected to the supporter, and
the ground section is configured to cut a radio frequency voltage applied by the radio frequency voltage application unit so that the supporter has a ground potential with respect to the direct current voltage.

3. The plasma treatment apparatus according to claims 1 or 2, wherein
the wafer transfer tray has a base formed of an insulating body, a first conductive layer for electrostatic attraction which forms the conductive member and which is embedded at a position in the vicinity of a first surface of the base, and a second conductive layer for electrostatic attraction embedded at a position in the vicinity of a second surface of the base and electrically connected to the first conductive layer, and
the direct current voltage application unit configured to apply a direct current voltage is connected to the first conductive layer and the second conductive layer.

4. The plasma treatment apparatus according to claim 1, wherein
the wafer transfer tray has a base formed of a high resistance body having a resistance value of 10⁸ Ω or more and 10¹¹ Ω or less, and a first conductive layer for electrostatic attraction embedded at a position in the vicinity of the first surface of the base, and
the direct current voltage application unit configured to apply a direct current voltage is connected to the first conductive layer.

5. The plasma treatment apparatus according to claim 1, wherein
the wafer transfer tray has a base formed of a metal, a first insulating layer disposed at the first surface of the base and in which a first conductive layer for electrostatic attraction forming the conductive member is embedded, and a second insulating layer disposed at the second surface of the base and in which a second conductive layer for electrostatic attraction forming the conductive member and electrically connected to the first conductive layer is embedded, and
the direct current voltage application unit configured to apply a direct current voltage is connected to the first conductive layer and the second conductive layer.

6. The plasma treatment apparatus according to claim 1 or 2, wherein
the wafer transfer tray has a base formed of a metal that constitutes a conductor for electrostatic attraction forming the conductive member, and an insulating layer configured to cover an outer circumferential surface of the base, and
a direct current voltage application unit configured to apply a direct current voltage is connected to the base.

7. The plasma treatment apparatus according to any one of claims 2 to 6, wherein
the ground section comprises a low-pass filter configured to cut an alternating current voltage having a predetermined frequency range applied to the supporter.

8. A wafer transfer tray (13) of a plasma treatment apparatus (10) comprising:
a wafer transfer tray (13) having a first surface and a second surface opposite to the first surface and configured to hold a wafer (W) on the first surface;
a cooling unit (25) configured to cool the wafer transfer tray (13);
a supporter (12) configured to support the second surface of the wafer transfer tray (13) and having a ground section setting a potential of the supporter (12) to a ground potential with respect to a direct current voltage; and
a conductor for electrostatic attraction connected to a direct current voltage application unit (26) configured to apply a direct current voltage and embedded in a base (21).

## Patentansprüche

1. Plasmabehandlungsvorrichtung (10) umfassend:
eine Waferübertragungsplatte (13), die eine erste Oberfläche und eine der ersten Oberfläche entgegengesetzte zweite Oberfläche aufweist und zum Halten eines Wafers (W) auf der ersten Oberfläche ausgelegt ist;
eine Kühleinheit (25), die zum Kühlen der Waferübertragungsplatte (13) ausgelegt ist;
eine leitfähige Stützvorrichtung (12), die zur Unterstützung der zweiten Oberfläche der Waferübertragungsplatte (13) ausgelegt ist; und
einen doppeloberflächigen elektrostatischen Attraktor (21, 22), der ausgelegt ist, um den Wafer (W) an die erste Oberfläche der Waferübertragungsplatte (13) monopolar-elektrostatisch anzuziehen und die Stützvorrichtung (12) an die zweite Oberfläche der Waferübertragungsplatte (13) monopolar-elektrostatisch anzuziehen, wobei der doppeloberflächige elektrostatische Attraktor (21, 22) ein leitfähiges Element umfasst, das aus einer leitfähigen Schicht (22) oder einem Leiter gebildet ist,
wobei
das leitfähige Element und die Stützvorrichtung (12) durch eine isolierende Schicht aneinander angezogen sind,
eine Gleichspannungsanlegungseinheit (26), die zum Anlegen einer Gleichspannung ausgelegt ist, mit dem doppeloberflächigen elektrostatischen Attraktor (21, 22) verbunden ist, und
ein Erdabschnitt (28) mit der Stützvorrichtung (12) derart verbunden ist, dass die Stützvorrichtung (12) ein Erdpotential bezüglich der Gleichspannung aufweist.

2. Plasmabehandlungsvorrichtung nach Anspruch 1, wobei eine Funkfrequenzspannungsanlegungseinheit mit der Stützvorrichtung verbunden ist, und der Erdabschnitt ausgelegt ist, um eine durch die Funkfrequenzspannungsanlegungseinheit angelegte Funkfrequenzspannung so abzubrechen, dass die Stützvorrichtung ein Erdpotential bezüglich der Gleichspannung aufweist.

3. Plasmabehandlungsvorrichtung nach Anspruch 1 oder 2, wobei
die Waferübertragungsplatte einen Basisteil, der aus einem Isolierkörper gebildet ist, eine erste leitfähige Schicht zur elektrostatischen Anziehung, die das leitfähige Element bildet und an einer Position in der Nähe einer ersten Oberfläche des Basisteils eingebettet ist, und eine zweite leitfähige Schicht zur elektrostatischen Anziehung aufweist, die an einer Position in der Nähe einer zweiten Oberfläche des Basisteils und mit der ersten leitfähigen Schicht elektrisch verbunden ist, und
die Gleichspannungsanlegungseinheit, die zum Anlegen einer Gleichspannung ausgelegt ist, mit der ersten leitfähigen Schicht und der zweiten leitfähigen Schicht verbunden ist.

4. Plasmabehandlungsvorrichtung nach Anspruch 1, wobei
die Waferübertragungsplatte einen Basisteil, der aus einem Körper hohen Widerstands bildet, der einen Widerstandswert von 10⁸ Ω oder mehr und 10¹¹ Ω oder weniger aufweist, und eine erste leitfähige Schicht zur elektrostatischen Anziehung aufweist, die an einer Position in der Nähe der ersten Oberfläche des Basisteils eingebettet ist, und
die Gleichspannungsanlegungseinheit, die zum Anlegen einer Gleichspannung ausgelegt ist, mit der ersten leitfähigen Schicht verbunden ist.

5. Plasmabehandlungsvorrichtung nach Anspruch 1, wobei
die Waferübertragungsplatte einen aus einem Metall gebildeten Basisteil, eine erste isolierende Schicht, die an der ersten Oberfläche des Basisteils angeordnet ist, und in welcher eine erste leitfähige Schicht zur elektrostatischen Anziehung, die das leitfähige Element bildet, eingebettet ist, und eine zweite isolierende Schicht aufweist, die an der zweiten Oberfläche des Basisteils angeordnet ist, und in welcher eine zweite leitfähige Schicht zur elektrostatischen Anziehung, die das leitfähige Element bildet und mit der ersten leitfähigen Schicht elektrisch verbunden ist, eingebettet ist, und
die Gleichspannungsanlegungseinheit, die zum Anlegen einer Gleichspannung ausgelegt ist, mit der ersten leitfähigen Schicht und der zweiten leitfähigen Schicht verbunden ist.

6. Plasmabehandlungsvorrichtung nach Anspruch 1 oder 2, wobei
die Waferübertragungsplatte einen aus einem Metall gebildeten Basisteil, der einen Leiter zur elektrostatischen Anziehung ausbildet, der das leitfähige Element bildet, und eine isolierende Schicht aufweist, die zur Überdeckung eine Außenumfangsfläche des Basisteils ausgelegt ist, und
eine Gleichspannungsanlegungseinheit, die zum Anlegen einer Gleichspannung ausgelegt ist, mit dem Basisteil verbunden ist.

7. Plasmabehandlungsvorrichtung nach einem der Ansprüche 2 bis 6, wobei der Erdabschnitt einen Tiefpassfilter umfasst, der zum Abbrechen einer Wechselstromspannung mit einem vorgegebenen Frequenzbereich, der auf die Stützvorrichtung angelegt ist, ausgelegt ist.

8. Waferübertragungsplatte (13) einer Plasmabehandlungsvorrichtung (10) umfassend:
eine Waferübertragungsplatte (13), die eine erste Oberfläche und eine der ersten Oberfläche entgegengesetzte zweite Oberfläche aufweist und zum Halten eines Wafers (W) auf der ersten Oberfläche ausgelegt ist;
eine Kühleinheit (25), die zum Kühlen der Waferübertragungsplatte (13) ausgelegt ist;
eine Stützvorrichtung (12), die zur Unterstützung der zweiten Oberfläche der Waferübertragungsplatte (13) ausgelegt ist und einen Erdabschnitt aufweist, der ein Potential der Stützvorrichtung (12) auf ein Erdpotential bezüglich einer Gleichspannung setzt; und
einen Leiter zur elektrostatischen Anziehung, die mit einer Gleichspannungsanlegungseinheit (26) verbunden ist, die zum Anlegen einer Gleichspannung ausgelegt und in einem Basisteil (21) eingebettet ist.

## Revendications

1. Dispositif de traitement au plasma (10), comprenant :
un plateau de transfert de tranche (13) ayant une première surface et une deuxième surface opposée à la première surface, et configuré pour maintenir une tranche (W) sur la première surface ;
une unité de refroidissement (25) configurée pour refroidir le plateau de transfert de tranche (13) ;
un support conducteur (12) configuré pour supporter la deuxième surface du plateau de transfert de tranche (13); et
un attracteur électrostatique à double surface (21, 22) configuré pour attirer électrostatiquement de manière monopolaire la tranche (W) vers la première surface du plateau de transfert de tranche (13) et pour attirer électrostatiquement de manière monopolaire le support (12) vers la deuxième surface du plateau de transfert de tranche (13), l'attracteur électrostatique à double surface (21, 22) comprenant un élément conducteur formé d'une couche conductrice (22) ou d'un conducteur,
dans lequel
l'élément conducteur et le support (12) sont attirés l'un vers l'autre par l'intermédiaire d'une couche isolante,
une unité d'application de tension à courant continu (26) configurée pour appliquer une tension à courant continu est connectée à l'attracteur électrostatique à double surface (21, 22), et
une section de masse (28) est connectée au support (12) si bien que le support (12) a un potentiel de masse par rapport à la tension à courant continu.

2. Dispositif de traitement au plasma selon la revendication 1, dans lequel une unité d'application de tension radiofréquence est connectée au support, et
la section de masse est configurée pour couper une tension de radiofréquence appliquée par l'unité d'application de tension de radiofréquence si bien que le support a un potentiel de masse par rapport à la tension à courant continu.

3. Dispositif de traitement au plasma selon la revendication 1 ou 2, dans lequel
le plateau de transfert de tranche a une base formée d'un corps isolant, une première couche conductrice pour une attraction électrostatique qui forme l'élément conducteur et qui est incorporée à une position au voisinage d'une première surface de la base, et une deuxième couche conductrice pour une attraction électrostatique incorporée à une position au voisinage d'une deuxième surface de la base et connectée électriquement à la première couche conductrice, et
l'unité d'application de tension à courant continu configurée pour appliquer une tension à courant continu est connectée à la première couche conductrice et à la deuxième couche conductrice.

4. Dispositif de traitement au plasma selon la revendication 1, dans lequel
le plateau de transfert de tranche a une base formée d'un corps à résistance élevée ayant une valeur de résistance de 10⁸ Ω ou plus et 10¹¹ Ω ou moins, et une première couche conductrice pour une attraction électrostatique incorporée à une position au voisinage de la première surface de la base, et
l'unité d'application de tension à courant continu configurée pour appliquer une tension à courant continu est connectée à la première couche conductrice.

5. Dispositif de traitement au plasma selon la revendication 1, dans lequel
le plateau de transfert de tranche a une base formée d'un métal, une première couche isolante disposée au niveau de la première surface de la base, et dans laquelle une première couche conductrice pour une attraction électrostatique formant l'élément conducteur est incorporée, et une deuxième couche isolante disposée au niveau de la deuxième surface de la base, et dans laquelle une deuxième couche conductrice pour une attraction électrostatique formant l'élément conducteur et connectée électriquement à la première couche conductrice est incorporée, et
l'unité d'application de tension à courant continu configurée pour appliquer une tension à courant continu est connectée à la première couche conductrice et à la deuxième couche conductrice.

6. Dispositif de traitement au plasma selon la revendication 1 ou 2, dans lequel
le plateau de transfert de tranche a une base formée d'un métal qui constitue un conducteur pour une attraction électrostatique formant l'élément conducteur, et une couche isolante configurée pour recouvrir une surface circonférentielle extérieure de la base, et
une unité d'application de tension à courant continu configurée pour appliquer une tension à courant continu est connectée à la base.

7. Dispositif de traitement au plasma selon l'une quelconque des revendications 2 à 6, dans lequel
la section de masse comprend un filtre passe-bas configuré pour couper une tension de courant alternatif ayant une plage de fréquences prédéterminée appliquée au support.

8. Plateau de transfert de tranche (13) d'un dispositif de traitement au plasma (10), comprenant :
un plateau de transfert de tranche (13) ayant une première surface et une deuxième surface opposée à la première surface, et configuré pour maintenir une tranche (W) sur la première surface ;
une unité de refroidissement (25) configurée pour refroidir le plateau de transfert de tranche (13) ;
un support (12) configuré pour supporter la deuxième surface du plateau de transfert de tranche (13) et ayant une section de masse définissant un potentiel du support (12) à un potentiel de masse par rapport à une tension à courant continu ; et
un conducteur d'attraction électrostatique connecté à une unité d'application de tension à courant continu (26) configurée pour appliquer une tension à courant continu et incorporée dans une base (21).
